# EUROPEAN PATENT SPECIFICATION

(11) **EP 2 790 212 B1**
(45) Date of publication and mention of the grant of the patent: **16.09.2015**
(21) Application number: 14176541.2
(22) Date of filing: 19.07.2012
(51) Int. Cl.: H01L 21/98, H01L 21/60, H01L 21/677, B23K 35/24

(54) **Method of self-assembly of components on a substrate**
Verfahren zur Selbstmontage von Komponenten auf einem Substrat
Procédé d'auto-assemblage de composants sur un substrat

(43) Date of publication of application: 15.10.2014
(62) Divisional of application: 12177060.6
(73) Proprietor: Technische Universität Ilmenau, 98693 Ilmenau (DE)
(72) Inventor: Jacobs, Heiko O., 98693 Ilmenau (DE)
(74) Representative: Geyer, Fehners & Partner

(56) References cited:
- EP-A1- 2 009 971
- WO-A2-2014/022619
- US-A1- 2001 023 985
- US-A1- 2003 215 981
- US-A1- 2008 023 435
- US-A1- 2010 096 439
- US-B2- 7 774 929
- CHIA-SHOU CHANG ET AL: "Self-Assembly of Microchips on Substrates", ELECTRONIC COMPONENTS AND TECHNOLOGY CONFERENCE 2006, 56TH SAN DIEGO, CA MAY 30 - JUNE 2, 2006, PISCATAWAY, NJ, USA,IEEE, 30 May 2006 (2006-05-30), pages 1533-1538, XP010923588, DOI: 10.1109/ECTC.2006.1645859 ISBN: 978-1-4244-0152-9

## Description

### Field of the Invention

The invention relates to a method of self-assembly including self-alignment of components on a substrate on the basis of surface tension of liquid solder for applications that require reliable operation of the self-assembled objects at elevated operation temperatures.

### Description of Prior Art

The construction of almost all man-made artifacts such as packaged LEDs, solid state lighting panels, cell phones, or computers relies on robotic assembly lines that place, package, and interconnect a variety of devices that have microscopic dimensions, i.e. with dimensions smaller than 1 mm. The key to the realization of these devices and systems is our ability to integrate/assemble components as well as to link/interconnect the components to transport energy and information. The tools of choice in the established manufacturing industry are robotic pick and place machines and wire bonding concepts. Conventional robotic methods, however, are challenged because of the difficulty in building machines that can economically manipulate and interconnect microscopic parts over large areas with high throughput. At the other extreme, nature forms materials, structures, and living systems by self-assembly on a molecular length scale. As a result self-assembly based fabrication strategies are widely recognized as inevitable tools in nanotechnology. However, self-assembly is not limited to the nanometer length scale. Strategies based on self-assembly are projected to have a major impact in the future manufacturing of macroscopic systems - with dimensions larger than 1 mm - that use microscopic building blocks.

In US 5,545,291 and US 6,780,696 a process is described to direct the assembly of small radio frequency identification (RFID) tags. Semiconductor chips are suspended in a liquid flow over a surface containing correspondingly shaped wells that act as receptors for the device components. The device components settle into these wells due to gravitational forces.

The process has the advantage that it produces a flat surface. Assembled components fill the wells and form a flush surface. Subsequent components slide over already assembled objects and there is little interference. This particular process has the advantage the self-assembled objects are not protruding. Scaling to large areas and continuous assembly on webs having widths of more than 10 cm has been possible with little effort in terms of the machine design. This process requires very specific die geometries - L or T shaped blocks for angular orientation and trapezoids to prevent up-side down assembly - these particular shapes are not common in the microelectronics industry; most dies are square in shape. While they remain valid solutions they limit wide spread use. Attempts of adoption by other manufacturers remain critically low because of the required use of trapezoidal chips that are not widely used. A more universal solution is desired and would increase the chance of technology adoption and transition.

An advantage of all self-assembly processes is that they are massively parallel, which potentially reduces the assembly costs dramatically relative to the costs of traditional deterministic pick and place methods that use serial robotic methods.

In the publication *"*Self-assembl y at all scales" from Whitesides et al., published in Science 295, p. 2418-2421 (2002), the use of surface tension to self-assemble components that are freely suspended in a liquid was described. In the publication *"*Self-assembly of mesoscale objects into ordered two-dimensional arrays" of Bowden et al., published in Science 276, p. 322-325 (1997), the self-assembly of components having a size of 5 mm with patterned hydrophobic surfaces into ordered aggregates has been described.

The concept of solder directed self-assembly is for example described and applied in US 7,774,929. The components self-assemble and attach to the solder-coated areas due to the reduction of the surface free energy of the liquid solder surface. The method has been applied to direct the assembly of chip-sized components onto surfaces from a heated suspension primarily in the context of solid state lighting, photovoltaic, and multicomponent sensors. One of the mechanisms of self-assembly and attachment of the chips is based on surface tension directed self-assembly on the basis of liquid solder. The self-assembly process is driven by the minimization of surface free energy of the liquid solder. A difference here when compared to the prior art on surface tension directed self-assembly at the time was that the solder was placed only on the receiving substrate to form a selective adhesive element for metal contacts on conventional semiconductor chips. The randomly moving self-assembly semiconductor chips themselves did not have a solder bump on their surface. In the particular design, the metal contact on the component binds to the liquid-solder-based-receptors during the self-assembly process at a temperature where the solder is molten. The solder wets the metal contact during the process and the minimization of the free surface area of the liquid solder drives the assembly into a stable, aligned position. The parallel assembly of large number of components has been accomplished using this process. The liquid-solder-coated areas act as receptors for subunits during the assembly - no manipulator is needed -, they form rigid bonds upon solidification - no adhesive is needed -, and provide electrical input/output-connectors to operate the final device - no wire bonder is needed.

Solder directed fluidic self-assembly as it has been described today is done inside a closed vial, barrel, or container to suspend the self-assembly components in a fluid at a temperature where the solder is molten.

A major limitation of solder directed self-assembly as it is known today is the fact that the melting point of the solder has to be below the boiling point of the fluid that is used in the fluidic self-assembly process. For example often water is used as a fluid which limits the melting point of the solder to be below 100°C. To assemble devices then mostly solder is used that has a melting point below 60°C. While it is possible to replace the water with ethylene glycol or other higher boiling point liquids, it has not yet been possible to form reliable interconnects using this approach. It appears that there are no solvents that support the self-assembly at sufficiently high temperatures that would work with the same solder based interconnects that are used in the electronics industry. This is the main reason why solder directed self-assembly has not been used in an industrial process today.

On the other hand, in the more established field of deterministic robotic flip chip assembly and packaging of semiconductor components sometimes a solder stack is used that is composed of two solder layers that have different compositions and thus different melting points. In this field the objects are always brought into contact using micromanipulators, referred to as deterministic rather than stochastic assembly.

In TW 517370 B for example the stack is used to avoid bridging between pads and to increase the bump height as well as to better control the bump dimensions.

Another example is described in US 5,872,400. There, solder balls are disclosed that have high melting point cores which are partially or completely coated with a lower melting point solder. The balls are applied in a ball grid array (BGA) and the particular process allows for a tighter control of the ball dimensions which in turn allows for higher interconnect density in surface mount packaging without bridging.

Another example is described in US 6,340,630. Again the layered system is used in the application field of BGA. The application describes transfer of solder bumps from a mold leading to BGA connection on a wafer that have a dual metallurgical composition after reflow.

Another example is described in WO 96/16442. The two layer solder bump is used in flip chip assembly as an interconnect material.

A further example is described in US 2001/0023985 A1. Here, two microelectronic elements are attached first temporarily together and, after testing has shown full functionality, are attached permanently together. A first microelectronic element, such as a semiconductor chip, is equipped with conductive contact bumps. Those are immersed in a first, molten solder contained in a tray, a low melting temperature conductive material. The coated bumps are then brought into contact with leads of a substrate such as a circuit board, where the low melting point conductive material and the bumps electrically interconnect the semiconductor chip with the substrate temporarily. The low melting temperature material is then reduced to a temperature below its melting point. If testing shows that the compound is fully functional, the elements are permanently attached to one another by raising the temperature of the conductive bumps to above the melting point of the material they consist of, inducing a reflow process in which the low melting temperature conductive material and the material of the conductive bumps mix, and subsequently cooling the alloy down below the melting point.

### Description of the Invention

An object of the invention is to enhance a self-assembly method based on solder in a way that also microelectronic components which have to withstand higher temperatures than currently achievable can be produced by using a self-assembly process as described in the beginning.

The problem is solved by a method as described in claim 1. Preferred and advantageous embodiments of the method are described in the dependent claims.

### Brief Description of the Drawings

Below, the invention will be explained in more detail with reference to the accompanying drawings, which also show features essential to the invention, among others, and in which
- Fig. 1: shows the principle of a self-assembly method using a solder stack,
- Fig. 2: shows an implementation using a conveyor belt,
- Fig. 3: shows another implementation of the method using pedestals,
- Fig. 4: shows the implementation of Fig. 3 using a conveyer belt.

### Detailed Description of the Drawings

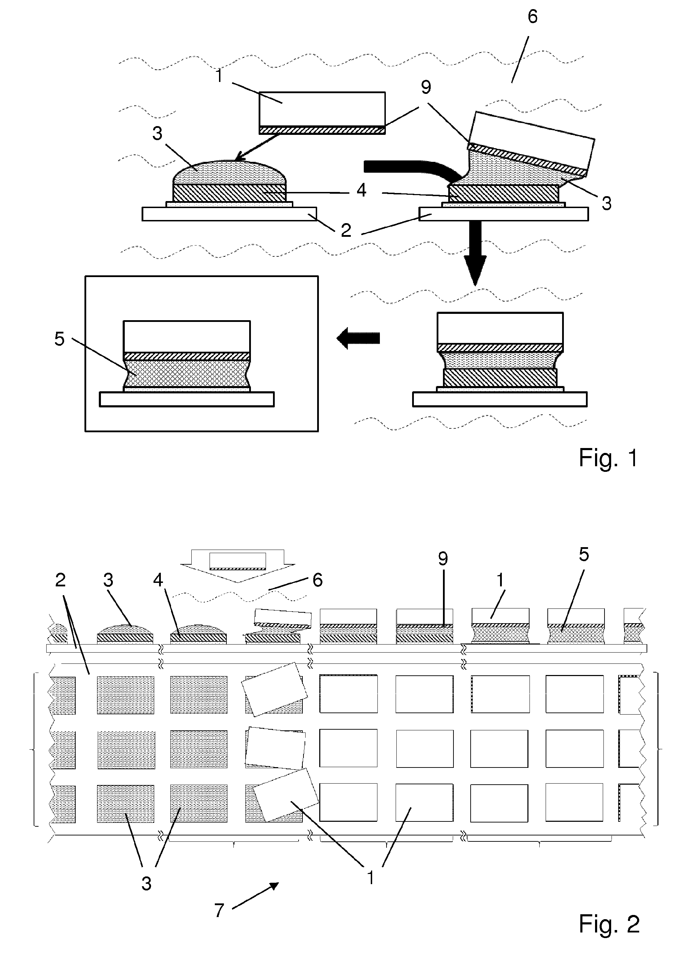

Figure 1 shows the basic concept of a method of self-assembly including self-alignment of components 1 on a substrate 2 on the basis of surface tension of liquid solder. The method involves a solder stack composed of an outermost layer of solder 3 on top and at least another layer of solder 4, the layers of solder having successively increasing melting points from top to bottom.

The method comprises the following steps: In a first step the solder stack is heated to a temperature between the melting point of the outermost layer of solder 3 and the at least another layer of solder 4. This corresponds to the situation shown in figure 1 in the upper left corner. The outermost layer 3 is molten; due to the surface tension the molten solder has a convex shape on its surface towards its environment since it tries to minimize its surface free energy. The molten outermost layer 3 is then used to form a receptor which adheres to the components 1 as shown in the upper right corner of figure 1. Since the molten solder tends to minimize its surface, when a component 1 is adhered to the solder, this will result in the self-assembly, self-alignment and attachment of the components 1. This situation is shown in the lower right corner of figure 1. The outermost layer of solder 3 is still molten. In the next step the solder stack is heated to a temperature above the melting point of the at least another layer of solder 4. This initialises a reflow soldering-process of the outermost and the at least another layer of solder 3, 4 to form a mixed solder layer as an alloy 5 to form an interconnect between the components and the substrate with a melting point higher than that of the outermost layer of solder 3. This situation is shown in the lower left corner of figure 1.

Melting of solder is achieved in a liquid environment, the liquid being heated but having a boiling point well above the melting point of the solder used in the outermost layer 3. The components 1 therefore are dispensed in a first fluid 6 which is also shown in the first three steps displayed in figure 1. The first fluid 6 is being heated to a temperature below its boiling point but above the melting point of the outermost layer of solder 3. This layer of solder 3 then forms a selective adhesive to capture the components 1 as shown in the upper right corner of figure 1.

To heat the at least another layer of solder 4 to a temperature above its melting point this environment has to be changed which is why the last step of the method displayed in the lower left corner of figure 1 is shown in a box. This step can for example be performed in a second fluid at a temperature above the boiling point of the first fluid, or in a gaseous environment like nitrogen or argon, as shown in figure 1.

This method overcomes the problem of prior solder directed self-assembly processes that used a single solder layer leading to an interconnect that had a melting point that was limited to be smaller than the boiling point of the first fluid 6 and where no reliable interconnects could be made which would withstand the higher operating temperatures of the assembled devices as they often occur in microdevices. It describes a two-face solder-based receptor to enable high temperature operation of self-assembled objects. However, this aspect is limited to the field of surface tension directed self-assembly on the basis of liquid solder. It extends the allowed operating temperature of current assemblies produced using prior art in the field of solder directed self-assembly which is somewhere in the range of 40-100°C to well above 200°C. The new kind of solder based receptor is composed of at least two different solder layers. The outermost layer of solder 3 is composed of a low melting point metal alloy and the at least another layer of solder 4 is composed of a higher melting point metal alloy. Using this new type of receptor the self-assembly process is divided into the aforementioned two-step sequence. The first step is carried out at low temperature where the low melting point section of the receptor is molten. Examples for low melting point alloys are various combinations of the element In, Bi, Sn, Zn, Cd, and Pb in different combination and ratios. To fulfil the *Restriction of Hazardous Substances Directive* (RoHS), lead and cadmium free solder alloys are also available. Different melting points of the solder can be realised using different alloys, for instance a melting point (MP) of 29.8° using 100% Ga, a MP of 47°C using an alloy of {44.7%Bi, 22.6% Pb, 19.1% In, 8.3% Sn, 5.3 % Cd}, a MP of 58°C using {49% Bi, 18% Pb, 12% Sn, 21% In}, a MP of 60°C using {51% In 32.5% Bi 16.5% Sn}, a MP of 69°C using {49% Bi, 18% Pb, 18% In, 15% Sn}, a MP of 79°C using {57% Bi, 26% In, 17% Sn}, a MP of 72 °C using {66.3% In, 33.7% Bi}, a MP of 79°C using {57% Bi, 26% In, 17% Sn}, a MP of 95°C using {52.5% Bi, 32% Pb, 15.5% Sn}, a MP of 103 °C using {54% Bi, 26% Sn, 20% Cd}, a MP of 108°C using { 52.2% In, 46% Sn, 1.8% Zn}, a MP of 118°C using {58% Sn, 42% In} or {50% Sn, 50% In}, a MP of 138°C using {57% Bi, 43% Sn}.These metal alloys work well due to high surface tension and fast wetting characteristic attaching to the metal contacts of the components 1. The first self-assembly step can and should therefore still be performed in a liquid environment at a modest temperature. For example, the first fluid 6 can be water, ethylene glycol or oil.

The second self-assembly step is a higher temperature reflow step which can be performed in a liquid having a higher boiling point than the first fluid, for example various oil, or inorganic and organic solvents can be used. It also can be performed in a gaseous environment like in air, nitrogen or argon. The temperature is raised to reflow both layers. The reflow step completes the self-assembly and final self-alignment while producing a reliable interconnect with increased melting point. The higher melting point solder layer can therefore be composed of a large variety of metallic alloys commonly also used in the electronics industry. Examples include alloys composed of Sn, Ag, Cu in different compositions (so-called SAC solder alloys), and Au. For example, an alloy composed of 93.6% Sn, 4.7% Ag, and 1.7% Cu has a melting point of 217°C, and a metal alloy composed of 80% Au, and 20% Sn has a melting point of 280°C. For instance, for packaging of power LED, solder paste SAC305 composed of 96.5% Sn, 3.0% Ag, and 0.5% Cu is used. The previously mentioned materials are only a few examples. The industry uses at least 40 different solder compositions and the list of possible combinations is extensive. While figure 1 shows similar thickness for the two solder layers 3 and 4, it is clear that the thickness of the respective layers can be adjusted to tune the melting point and composition of the mixed phase that is formed after reflow. For example, if a rather high melting point should be achieved, the thickness of the at least another layer of solder 4 should be higher than that of the outermost layer of solder 3. The composition of the final solder can be tuned to achieve a desired melting point or physical property by selecting a composition of the first solder and thickness and a composition of the second solder and thickness.

This new type of self-assembly process allows to use a solder stack to form reliable and resilient electrical or mechanical connections, either single or multiple, between the components 1 and the substrate 2, the components 1 being for example semiconductor chips, dies, LED for solid state lighting, RFID-tags, and/or even mechanical parts.

In an advantageous embodiment to enable assembly in large volumes, the substrate 2 has multiple receptor sites mounted on a conveyor belt. An example is shown in figure 2, with a substrate 2 on a conveyor belt 7 moving from left to right through the respective temperature regions. Displayed are four zones, marked by the small curved double lines dividing the conveyor belt 7 and the substrate 2, respectively, in different regions. The first region on the left is used to melt the outermost layer of solder 3 which drives the self-assembly of the components 1 into a stable and self-aligned position in the next region. This step takes place in the first fluid 6, while the outermost layer of solder 3 is molten before entering the first fluid 6. When the components 1 are self-aligned and fixed at their positions, they enter a third region where they can be inspected for example, either manually or by an automatic process using image processing, the latter being the process of choice since the solder stack is repeatedly arranged over an extended surface area and comprises a large number of receptor sites. The next step shown in a fourth region on the right side of figure 2 corresponds to the high temperature reflow step of the entire solder stack to form an interconnecting alloy with sufficiently high melting point to ensure operation in real world electronic applications.

Instead of mounting the substrate 2 on a conveyor belt 7, the substrate 2 can also be mounted on a web; it is also possible that the web itself forms the substrate 2.

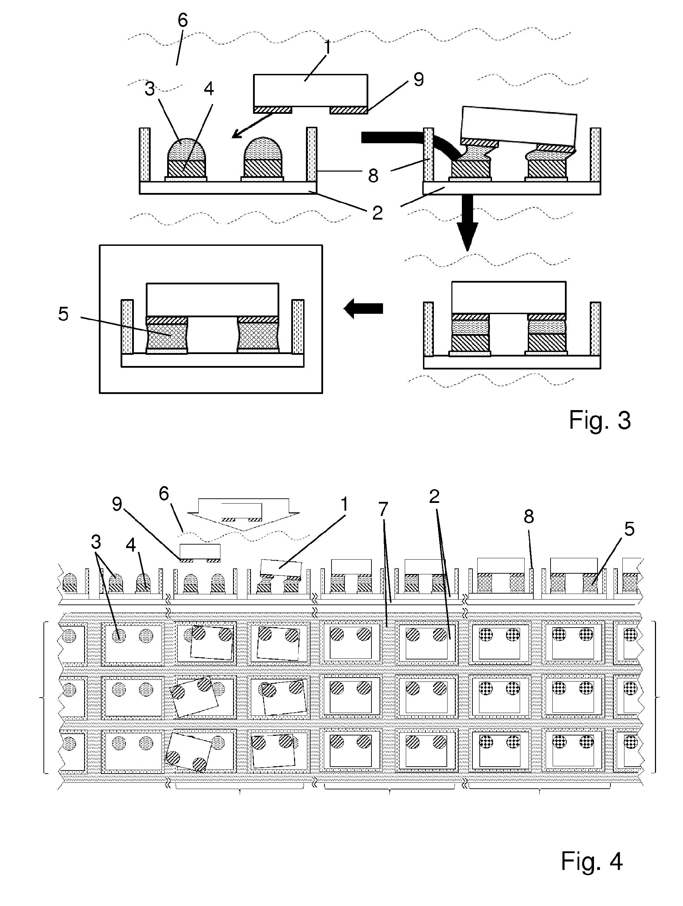

Referring now to figure 3, in another advantageous embodiment pedestals 8 are used on the substrate 2 in combination with the solder stack to define docking sites to assemble components 1 onto the surface of the substrate 2 with unique angular rotation and/or contact pad registration. Instead of having only one metal contact 9 like the components 1 shown in figure 1, the components 1 displayed in figure 3 have two metal contacts 9, they therefore have to be aligned with correct orientation on the substrate to ensure their function. To achieve correct orientation and electrical connections of the components 1 as an integral part of the self-assembly process using the solder stacks, pedestals 8 are used which divide the substrate into different regions. This embodiment is in particular advantageous when used together with a conveyor belt 7 as shown in figure 4, or webs. In figure 4, the components 1 are displayed in a transparent manner to make to contact pads on the surface of the substrate 2 and on the components 1 visible. The process easily can be extended to more than two connections.

### List of reference numerals

- 1: component
- 2: substrate
- 3: outermost layer of solder
- 4: another layer of solder
- 5: alloy
- 6: first fluid
- 7: conveyor belt
- 8: pedestal
- 9: metal contact

## Claims

1. Method of self-assembly including self-alignment of components (1) on a substrate (2) on the basis of surface tension of liquid solder, involving a solder stack on said substrate, said solder stack being composed of an outermost layer of solder (3) on top and at least another layer of solder (4) between said outermost layer of solder and said substrate, the layers of solder having successively increasing melting points from top to bottom, the method comprising the
steps of:
i) dispensing the components (1) in a first fluid (6), the first fluid (6) being heated to a temperature below its boiling point but above the melting point of the outermost layer of solder (3), thereby heating the solder stack to a temperature between the melting point of the outermost layer of solder (3) and the at least another layer of solder (4) to form a selective adhesive to capture the components (1),
ii) using the molten outermost layer (3) to form a receptor which adheres to the components (1), resulting in the self-assembly, self-alignment, and attachment of the components (1),
iii) heating the solder stack to a temperature above the melting point of the at least another layer of solder (4), thereby
iv) initialising a reflow soldering-process of the outermost and the at least another layer of solder (3, 4) to form a mixed solder layer as an alloy (5) to form an interconnect between the components (1) and the substrate (2) with a melting point higher than that of the outermost layer of solder (3).

2. Method of self-assembly according to claim 1, **characterized in that** step iii) and iv) are performed in a second fluid at a temperature above the boiling point of the first fluid, or in a gaseous environment, preferably nitrogen or argon.

3. Method of self-assembly according to one of claims 1 or 2, **characterized in that** the solder stack is used to form electrical or mechanical connections, either single or multiple, between the components (1) and the substrate (2), the components (1) being semiconductor chips, dies, LED for solid state lighting, or RFID tags and/or mechanical parts.

4. Method according to one of claims 1 to 3, **characterized in that** pedestals (8) are used on the substrate (2) and divide the substrate (2) into different regions, said pedestrals being used in combination with the solder stack to define docking sites to assemble components (1) onto the surface of the substrate (2) with unique angular rotation and/or contact pad registration.

## Patentansprüche

1. Verfahren zur Selbstassemblierung einschließlich Selbstausrichtung von Komponenten (1) auf einem Substrat (2), basierend auf der Oberflächenspannung flüssigen Lots, umfassend einen Lotstapel auf dem Substrat, wobei der Lotstapel aus einer äußersten Lotschicht (3) zuoberst und mindestens einer weiteren Lotschicht (4) zwischen der äußersten Lotschicht (3) und dem Substrat (2) zusammengesetzt ist, wobei die Lotschichten von oben nach unten sukzessive ansteigende Schmelzpunkte haben, wobei das Verfahren die Schritte umfasst:
i) Verteilen der Komponenten (1) in einer ersten Flüssigkeit (6), wobei die erste Flüssigkeit (6) auf eine Temperatur unterhalb ihres Siedepunkts, jedoch oberhalb des Schmelzpunktes der äußersten Lotschicht (3) erwärmt ist, wodurch der Lotstapel auf eine Temperatur zwischen dem Schmelzpunkt der äußersten Lotschicht (3) und der mindestens einen weiteren Lotschicht (4) erwärmt wird, um ein selektives Haftmittel zum Einfangen der Komponenten (1) zu bilden,
ii) Verwenden der geschmolzenen äußersten Lotschicht (3), um einen Empfänger zu bilden, welcher an den Komponenten (1) anhaftet, resultierend in der Selbstassemblierung, der Selbstausrichtung und der Anlagerung der Komponenten (1),
iii) Erwärmen des Lotstapels auf eine Temperatur oberhalb des Schmelzpunktes der mindestens einen weiteren Lotschicht (4), dadurch
iv) Initialisierung eines Aufschmelzlötprozesses der äußersten Lotschicht (3) und der mindestens einer weiteren Lotschicht (4) zur Bildung einer gemischten Lotschicht als Legierung (5), um eine Verbindung zwischen den Komponenten (1) und dem Substrat (2) mit einem Schmelzpunkt, welcher höher als derjenige der äußersten Lotschicht (3) ist, zu bilden.

2. Verfahren zur Selbstassemblierung nach Anspruch 1, **dadurch gekennzeichnet, dass** die Schritte iii) und iv) in einer zweiten Flüssigkeit bei einer Temperatur oberhalb des Siedepunktes der ersten Flüssigkeit, oder in einer gasförmigen Umgebung, vorzugsweise einer Stickstoff- oder Argon-Umgebung durchgeführt werden.

3. Verfahren zur Selbstassemblierung nach einem der Ansprüche 1 oder 2, **dadurch gekennzeichnet, dass** der Lotstapel verwendet wird, um entweder einfache oder vielfache elektrische oder mechanische Verbindungen zwischen den Komponenten (1) und dem Substrat (2) zu bilden, wobei die Komponenten (1) als elektronische Halbleiter-Bausteine, Chips, LED zur Festkörperbeleuchtung, als RFID-Schilder und / oder als mechanische Teile ausgestaltet sind.

4. Verfahren nach einem der Ansprüche 1 bis 3, **dadurch gekennzeichnet, dass** auf dem Substrat (2) Sockel (8) verwendet werden, welche das Substrat (2) in verschiedene Bereiche aufteilen, wobei die Sockel (8) in Kombination mit dem Lotstapel verwendet werden, um Andockplätze zu definieren, um die Komponenten (1) auf der Oberfläche des Substrates (2) mit eindeutiger Winkelverdrehung und/oder Kontaktplättchen-Registrierung anzusammeln.

## Revendications

1. Procédé d'auto-assemblage comprenant l'auto-alignement de composants (1) sur un substrat (2) sur la base d'une tension superficielle de soudure liquide, impliquant un empilage de soudures sur ledit substrat, ledit empilage de soudures étant composé d'une couche de soudure la plus à l'extérieur (3) sur le dessus et d'au moins une autre couche de soudure (4) entre ladite couche de soudure la plus à l'extérieur et ledit substrat, les couches de soudure ayant des points de fusion successivement croissants du haut vers le bas, le procédé comprenant les étapes :
i) de distribution des composants (1) dans un premier fluide (6), le premier fluide (6) étant chauffé à une température inférieure à son point d'ébullition mais au-dessus du point de fusion de la couche de soudure la plus à l'extérieur (3), chauffant de ce fait l'empilage de soudures à une température entre les points de fusion de la couche de soudure la plus à l'extérieur (3) et de ladite au moins une autre couche de soudure (4) pour former un adhésif sélectif pour capturer les composants (1),
ii) d'utilisation de la couche la plus à l'extérieur (3) fondue pour former un récepteur qui adhère aux composants (1), résultant en l'auto-assemblage, l'auto-alignement et la fixation des composants (1),
iii) de chauffage de l'empilage de soudures à une température au-dessus du point de fusion de ladite au moins une autre couche de soudure (4), de ce fait
iv) d'initialisation d'un processus de soudage par refusion de la couche de soudure la plus à l'extérieur et de ladite au moins une autre couche de soudure (3, 4) pour former une couche de soudure mixte en tant qu'alliage (5) pour former une interconnexion entre les composants (1) et le substrat (2) avec un point de fusion plus élevé que celui de la couche de soudure la plus à l'extérieur (3).

2. Procédé d'auto-assemblage selon la revendication 1, **caractérisé en ce que** les étapes iii) et iv) sont effectuées dans un deuxième fluide à une température au-dessus du point d'ébullition du premier fluide, ou dans un environnement gazeux, de préférence de l'azote ou de l'argon.

3. Procédé d'auto-assemblage selon l'une des revendications 1 ou 2, **caractérisé en ce que** l'empilage de soudures est utilisé pour former des connexions électriques ou mécaniques, soit uniques, soit multiples, entre les composants (1) et le substrat (2), les composants (1) étant des composants semi-conducteurs, des puces, des DEL pour un éclairage à semi-conducteurs, ou des étiquettes RFID et/ou des pièces mécaniques.

4. Procédé selon l'une des revendications 1 à 3, **caractérisé en ce que** des socles (8) sont utilisés sur le substrat (2) et divisent le substrat (2) en différentes régions, lesdits socles étant utilisés en combinaison avec l'empilage de soudures pour définir des sites d'accueil pour assembler les composants (1) sur la surface du substrat (2) avec une rotation angulaire et/ou un alignement de pastille de contact unique.
